# EUROPÄISCHE PATENTANMELDUNG

(11) **EP 4 137 981 A1**
(43) Veröffentlichungstag der Anmeldung: **22.02.2023**
(21) Anmeldenummer: 21191900.6
(22) Anmeldetag: 18.08.2021
(51) Int. Cl.: G06F 30/12, G06F 30/13

(54) **GENERIERUNG EINES GEBÄUDEINFORMATIONSMODELLS**

(71) Anmelder: Siemens Schweiz AG, 8047 Zürich (CH)
(72) Erfinder: Heinrich, Veronika, 80339 München (DE); Mayer, Hermann Georg, 83209 Prien am Chiemsee (DE)
(74) Vertreter: Maier, Daniel Oliver

(57) **Zusammenfassung**

Verfahren und System zur Generierung eines Gebäudeinformationsmodells, insbesondere eines BIM-Modells, zur Bearbeitung eines Gebäudes. Es wird ein zweidimensionaler, digitalisierter Gebäudeplan des Gebäudes eingelesen (S1), wobei der Gebäudeplan, Gebäudeobjekte und Gebäudeobjektdaten, die den Gebäudeobjekten zugeordnet sind, umfasst. Mittels einer Abtasteinheit werden dreidimensionale Gebäudedaten erfasst (S2), welche mit dem Gebäudeplan verglichen werden (S3). Anhand der Vergleichsdaten wird ein Gebäudeobjekt im Gebäudeplan detektiert (S4) und dessen Gebäudeobjektdaten werden ausgegeben. Aus den dreidimensionalen Gebäudedaten wird das Gebäudeinformationsmodell generiert (S5) und das detektierte Gebäudeobjekt und dessen Gebäudeobjektdaten werden ins Gebäudeinformationsmodell integriert (S6). Das Gebäudeinformationsmodell wird zum Bearbeiten des Gebäudes ausgegeben (S7).

## Beschreibung

Die Erfindung betrifft ein Verfahren und ein System zur Generierung eines Gebäudeinformationsmodells, sowie ein Computerprogrammprodukt, das dazu geeignet ist, die Schritte des Verfahrens durchzuführen.

In der Bauindustrie gibt es einen hohen Digitalisierungsbedarf für Bestandsgebäude. Für diese existiert allerdings häufig weder ein sog. BIM-Modell, wobei "BIM" für "Building Information Modeling" (dt. Gebäudemodellierung oder Bauwerksdatenmodellierung) steht und auch als Gebäudeinformationsmodell bezeichnet werden kann, noch ein sonstiges digitales 3D-Modell. Diese wären beispielsweise hilfreich hinsichtlich aufkommender Renovierungs- und Sanierungsarbeiten eines Gebäudes. Mit einem BIM-Modell und entsprechender BIM-Software können BIM-Prozesse wie Materialabschätzungen, statische Analysen und weitere Analysen unter Verwendung von Drittanbietertools, wie z.B. Fluchtweg-Simulationen, durchgeführt werden.

Stattdessen liegen oftmals lediglich zweidimensionale Pläne (2D-Pläne) vor, aus denen dreidimensionale Modelle (3D-Modelle) erzeugt werden können. Diese 3D-Modelle können mittels einer Objekterkennung mit formalen Objektbeschreibungen, wie z.B. Türen und Fenster, ergänzt werden. Allerdings kann sich bei diesem Verfahren das Problem ergeben, dass Änderungen am Gebäude, wie z.B. Entfernung einer Wand, nicht im ursprünglichen 2D-Plan dokumentiert sind. Dadurch ergibt sich daraus ein 3D-Modell, das nicht den aktuellen Zustand des physischen Gebäudes abbildet.

Alternativ zu diesem Verfahren kann auch mittels eines Laser-Scans ein 3D-Punktwolkenmodell eines Gebäudes erzeugt werden. Bei dieser Methode wird sichergestellt, dass das 3D-Modell dem aktuellen Stand des Gebäudes entspricht. Der Nachteil an diesem Verfahren ist, dass eine Vielzahl an Informationen, wie z.B. die Dicke oder das Material einer Wand, in den gescannten Oberflächen nicht enthalten ist und nachträglich im Gebäudemodell eingegeben werden muss. Diese Anpassung des erzeugten Gebäudemodells ist in der Regel zeitaufwendig und kann fehleranfällig sein, da ein Informationsaustausch über mehrere Schnittstellen und/oder Personen verschiedener Gewerke erforderlich ist. Bei der Erzeugung eines 3D-Modells aus einer Punktwolke aus einem 3D-Scan werden die Räume eines Gebäudes nacheinander mit einem Laser gescannt. Hier können bei der Zusammenführung der einzelnen Räume im Gesamtmodell des Gebäudes außerdem Ungenauigkeiten auftreten, weil die Punktwolkendarstellung einer identischen Wand, gescannt von zwei Seiten, nicht ausreichend referenziert werden kann. Mit dem Prinzip der Raumerkennung kann der Aufnahmebereich anhand seiner spezifischen Raumgeometrie im Gesamtplan oft hinreichend gut lokalisiert werden. Das Verfahren stößt allerdings bei Gebäuden mit einer Vielzahl identischer Räume (wie z.B. Hotels oder Bürokomplexe) an seine Grenzen, weil hier die Räume nicht anhand von typischen Objekten (regel- oder datenbasiert) eindeutig differenziert werden können und zusätzlich die Geoposition getrackt werden muss, um die Räume im 3D-Modell richtig miteinander zu verbinden.

Es ist daher eine Aufgabe der Erfindung, die Generierung eines 3D-Gebäudeinformationsmodells für ein Gebäude zu verbessern.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein Verfahren zur Generierung eines Gebäudeinformationsmodells zum Bearbeiten eines Gebäudes, umfassend die Verfahrensschritte:
a) Einlesen eines zweidimensionalen, digitalisierten Gebäudeplans des Gebäudes, wobei der Gebäudeplan Gebäudeobjekte und Gebäudeobjektdaten, die den Gebäudeobjekten zugeordnet sind, umfasst,
b) Erfassen dreidimensionaler Gebäudedaten von mindestens einem Teil des Gebäudes mittels einer Abtasteinheit,
c) Vergleichen der dreidimensionalen Gebäudedaten mit dem Gebäudeplan, wobei mindestens ein Teilbereich des Gebäudeplans an einer Position der Abtasteinheit ausgewertet wird, und Ausgeben von Vergleichsdaten,
d) Detektieren von mindestens einem Gebäudeobjekt im Gebäudeplan anhand der Vergleichsdaten und Ausgeben von Gebäudeobjektdaten, die dem detektierten Gebäudeobjekt zugeordnet sind,
e) Generieren des Gebäudeinformationsmodells aus den dreidimensionalen Gebäudedaten,
f) Integrieren des detektierten Gebäudeobjekts und die zugeordneten Gebäudeobjektdaten in das Gebäudeinformationsmodell, und
g) Ausgeben des generierte Gebäudeinformationsmodells zum Bearbeiten des Gebäudes.

Das Verfahren kann insbesondere zumindest teilweise computer-/rechnergestützt bzw. computerimplementiert sein, wobei beispielsweise eine Implementierung des Verfahrens verstanden werden, bei dem insbesondere ein Prozessor mindestens einen Verfahrensschritt des Verfahrens ausführt. Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens, der Komponente, der Module, oder anderer Aspekte und/oder Teilaspekte der Erfindung realisiert.

Sofern es in der nachfolgenden Beschreibung nicht anders angegeben ist, beziehen sich die Begriffe "durchführen", "berechnen", "rechnergestützt", "rechnen", "feststellen", "generieren", "konfigurieren", "rekonstruieren" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "Bereitstellen", insbesondere in Bezug auf Daten und/oder Informationen, kann im Zusammenhang mit der Erfindung beispielsweise ein rechnergestütztes Bereitstellen verstanden werden. Das Bereitstellen erfolgt beispielsweise über eine Schnittstelle, wie z. B. eine Netzwerkschnittstelle, eine Kommunikationsschnittstelle oder eine Schnittstelle zu einer Speichereinheit. Über eine solche Schnittstelle können beispielsweise beim Bereitstellen entsprechende Daten und/oder Informationen übermittelt und/oder gesendet und/oder abgerufen und/oder empfangen werden.

Unter einem "Gebäudeinformationsmodell" kann im Zusammenhang der Erfindung insbesondere ein (3D-)BIM-Modell bzw. Building-Information-Modeling-Modell verstanden werden. Ein Gebäudeinformationsmodell umfasst insbesondere Gebäudedaten in drei Dimensionen (3D). Insbesondere werden alle relevanten Gebäudedaten digital modelliert, kombiniert und erfasst. Außerdem kann ein Gebäudeinformationsmodell weiter Informationen, wie z.B. zu Baumaterial, umfassen.

Unter einer "Abtasteinheit" kann beispielsweise ein Scanner oder Laser-Scanner verstanden werden. Unter "Abtasten" kann somit beispielsweise Scannen verstanden werden. Mit der Abtasteinheit kann das Gebäude bzw. Teile des Gebäudes in drei Dimensionen in einem kartesischen Koordinatensystem abgetastet/abgescannt, d.h. Daten bzw. Gebäudedaten gemessen/genommen, werden. Somit stellt die Abtasteinheit insbesondere dreidimensionale (3D) Gebäudedaten bereit. Beispielsweise können die dreidimensionalen Gebäudedaten als Punkte bzw. als Punktwolke ausgegeben werden, d.h. einzelne Messdaten denen jeweils dreidimensionale Koordinaten zugeordnet sind. Unter "Gebäudedaten" können beispielsweise auch Flächen, Ecken, Wände, Formen etc. verstanden werden, die mittels einer Abtasteinheit/eines Scanners erfasst werden können.

Es ist ein Vorteil der vorliegenden Erfindung, dass ein Gebäudeinformationsmodell auf einfache Weise und mit geringem Rechenaufwand generiert werden kann. Es wird insbesondere der essenzielle und sonst aufwendige Bearbeitungsschritt der Objekterkennung automatisiert, indem während der Erfassung der dreidimensionalen Daten und der daraus folgenden Generierung des Gebäudeinformationsmodells Informationen anhand der Punktwolke der 3D-Daten und des Gebäudeplans extrahiert werden. Dies reduziert den Aufwand der manuellen Nachbearbeitung des Gebäudeinformationsmodells/BIM-Modells.

Die Erfindung ermöglicht somit eine Erzeugung eines 3D-BIM-Modells auf Basis eines zweidimensionalen (2D) Plans und einer Punktwolke. Wird während des Scans die erzeugte Punktwolke mit verschiedenen 2D-Plänen, wie z.B. Grundriss, Stromlaufplan etc., abgeglichen, so können die entsprechenden formalen Informationen bereits ins BIM-Modell aufgenommen werden bzw. die detektierten Unterschiede in den Plan übertragen werden. Eine solche Synchronisierung kann beispielsweise durch das Fahren des Scanners entlang einer vordefinierten Trajektorie ermöglicht werden. Dieses Tracking-Verfahren hat den Vorteil, dass die begrenzte Genauigkeit des GPS-Signals im Gebäudeinneren im Gegensatz zur GPS-basierter Lokalisierung keine Rolle mehr spielt.

Das derart erzeugte Gebäudeinformationsmodell wird zum Bearbeiten des Gebäudes bereitgestellt. Unter "Bearbeiten des Gebäudes" kann insbesondere eine Instandsetzung, Sanierung, Renovierung, o.ä. des Gebäudes verstanden werden. Es ist auch denkbar, dass das Gebäudemodell beispielsweise für weitere Analysen, wie z.B. der Gebäudestatik, oder für eine computergestützte Simulation eines Prozesses im Gebäude, wie z.B. eine Personenstromsimulation, genutzt wird.

In einer vorteilhaften Ausführungsform des Verfahrens können die dreidimensionalen Gebäudedaten durch Abtasten des Gebäudes mittels der Abtasteinheit entlang einer im Gebäudeplan definierten Trajektorie erfasst werden.

Dies erleichtert beispielsweise das Vergleichen bzw. Synchronisieren der 3D-Gebäudedaten mit dem 2D-Gebäudeplan.

In einer vorteilhaften Ausführungsform des Verfahrens kann anhand des Gebäudeplans ein Startpunkt bestimmt werden und die dreidimensionalen Gebäudedaten können ausgehend von diesem Startpunkt erfasst werden.

Dadurch wird beispielsweise das Referenzieren des Gebäudeplans und der dreidimensionalen Gebäudedaten verbessert. Beispielsweise können die Gebäudedaten ausgehend vom Startpunkt entlang einer anhand des Gebäudeplans festgelegten Trajektorie erfasst werden, wobei die Abtasteinheit die Gebäudedaten entlang der Trajektorie erfasst.

In einer Ausführungsform des Verfahrens können die Verfahrensschritte b) bis d), d.h. die Verfahrensschritte des Erfassens, des Vergleichens und des Detektierens, nach vorgegebenen Zeitschritten wiederholt werden.

In einer alternativen Ausführungsform des Verfahrens können die Verfahrensschritte b) bis d), d.h. die Verfahrensschritte des Erfassens, des Vergleichens und des Detektierens, nach einer Detektion eines Gebäudeobjektes wiederholt werden.

Durch das iterative Vorgehen kann das Gebäudeinformationsmodell im Wesentlichen während des Scans erstellt werden.

In einer weiteren Ausführungsform des Verfahrens kann anhand der Vergleichsdaten eine Abweichung der dreidimensionalen Gebäudedaten vom Gebäudeplan detektiert werden.

Durch den Vergleich der aktuellen, gemessenen Gebäudedaten mit den Strukturen im Gebäudeplan, können auf Änderungen am Gebäude, wie z.B. eine fehlende oder hinzugefügte Wand, schnell erfasst werden. Beispielsweise kann ein Signal oder ein Warnhinweis ausgegeben werden, wenn eine Abweichung detektiert wurde.

In einer weiteren Ausführungsform des Verfahrens können, falls eine Abweichung erkannt wird, ein Gebäudeobjekt und entsprechende Gebäudeobjektdaten in Abhängigkeit der dreidimensionalen Gebäudedaten generiert und in das Gebäudeinformationsmodell integriert werden.

Vorzugsweise werden Gebäudeobjektdaten generiert, die die dreidimensionalen Gebäudedaten reproduzieren. Auf diese Weise kann das Gebäudeinformationsmodell anhand der 3D-Daten mit zusätzlichen Informationen ergänzt werden.

In einer weiteren Ausführungsform des Verfahrens kann der Verfahrensschritt des Vergleichens der dreidimensionalen Gebäudedaten mit dem Gebäudeplan folgende Teilschritte umfassen:
- Bestimmen einer horizontalen Struktur anhand der dreidimensionalen Gebäudedaten,
- Generieren einer ersten Linie anhand der horizontalen Struktur,
- Vergleichen der ersten Linie mit Linien des Gebäudeplans, wobei die erste Linie einer zweiten Linie des Gebäudeplans zugeordnet wird,
   und
- Korrigieren der räumlichen Koordinaten der dreidimensionalen Gebäudedaten, die der ersten Linie zugeordnet sind, in Abhängigkeit der Position der zweiten Linie.

Dies erhöht insbesondere die Genauigkeit des Gebäudeinformationsmodells, insbesondere im Wandbereich oder bei Ecken.

In einer weiteren Ausführungsform des Verfahrens kann das mindestens eine Gebäudeobjekt anhand der zweiten Linie im Gebäudeplan detektiert werden.

Beispielsweise können die erste und die zweite Linie abgeglichen, z.B. in Übereinstimmung gebracht werden, und damit das Gebäudeobjekt bestimmt werden, welches der zweiten Linie zugeordnet ist.

In einer weiteren Ausführungsform des Verfahrens kann die horizontale Struktur anhand der dreidimensionalen Gebäudedaten detektiert werden, indem in vertikaler Richtung übereinanderliegende Datenpunkte gezählt werden und horizontal mit benachbarten Datenpunkten entlang des jeweilig obersten Datenpunkts verbunden werden, sofern die benachbarten Datenpunkte in vertikaler Richtung eine im Wesentlichen übereinstimmenden Anzahl aufweisen.

Diesem Vorgehen liegt die Annahme zu Grunde, dass die meisten Strukturen in einem Gebäude in der Regel senkrecht zur Oberfläche stehen. Es erlaubt eine automatisierte Detektion von Gebäudeobjekten anhand der dreidimensionalen Gebäudedaten. Die Ausdehnung in z-Richtung/vertikaler Richtung kann anhand der dreidimensionalen Gebäudedaten bestimmt werden.

In einer alternativen Ausführungsform des Verfahrens kann der Verfahrensschritt des Vergleichens der dreidimensionalen Gebäudedaten mit dem Gebäudeplan mittels eines dafür trainierten maschinellen Lernmodells durchgeführt werden.

Ein maschinelles Lernmodell kann beispielsweise ein neuronales Netz sein. Das maschinelle Lernmodell ist beispielsweise mittels Trainingsdaten darauf trainiert, eine dreidimensionale Struktur mit einer zweidimensionalen Struktur in einem Gebäudeplan zu vergleichen. Die Trainingsdaten können hierfür beispielsweise dreidimensionale Gebäudedaten als Eingabedaten und zweidimensionale Daten von Gebäudeplänen als Ausgabedaten umfassen. Das maschinelle Lernmodell wird dann darauf trainiert, die Eingabedaten den Ausgabedaten zuzuordnen und/oder bei mangelnder Übereinstimmung eine Meldung auszugeben. Das trainierte maschinelle Lernmodell kann anschließend bereitgestellt werden.

In einer Ausführungsform des Verfahrens kann der Gebäudeplan ein Grundriss oder ein Elektroinstallationsplan sein.

In einer Ausführungsform des Verfahrens kann das Gebäudeinformationsmodell ein BIM-Modell sein.

Gemäß einem zweiten Aspekt betrifft die Erfindung ein System zur Generierung eines Gebäudeinformationsmodells zum Bearbeiten eines Gebäudes, umfassend:
- eine Schnittstelle, die derart eingerichtet ist, einen zweidimensionalen Gebäudeplan des Gebäudes einzulesen, wobei der zweidimensionale Gebäudeplan Gebäudeobjekte und Gebäudeobjektdaten, die den Gebäudeobjekten zugeordnet sind, umfasst,
- eine Abtasteinheit, die derart eingerichtet ist, dreidimensionale Gebäudedaten von mindestens einem Teil des Gebäudes zu erfassen,
- eine Vergleichseinheit, die derart eingerichtet ist, die dreidimensionalen Gebäudedaten mit dem Gebäudeplan zu vergleichen, wobei mindestens ein Teilbereich des Gebäudeplans an der Position der Abtasteinheit ausgewertet wird, und Vergleichsdaten auszugeben,
- eine Detektionseinheit, die derart eingerichtet ist, anhand der Vergleichsdaten mindestens ein Gebäudeobjekt im Gebäudeplan zu detektieren und Gebäudeobjektdaten, die dem detektierten Gebäudeobjekt zugeordnet sind, auszugeben,
- einen Modellgenerator, der derart eingerichtet ist, aus den dreidimensionalen Gebäudedaten das Gebäudeinformationsmodell zu generieren,
- eine Integrationseinheit, die derart eingerichtet ist, das detektierte Gebäudeobjekt und die zugeordneten Gebäudeobjektdaten in das Gebäudeinformationsmodell zu integrieren,
   und
- eine Ausgabeeinheit, die derart eingerichtet ist, das generierte Gebäudeinformationsmodell zum Bearbeiten des Gebäudes auszugeben.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, die Schritte eines erfindungsgemäßen Verfahrens auszuführen.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele der Erfindung sind in den Zeichnungen beispielhaft dargestellt und werden anhand der nachfolgenden Beschreibung näher erläutert. Es zeigen:
- Fig. 1:: ein Flussdiagramm eines ersten Ausführungsbeispiels des Verfahrens zur Generierung eines Gebäudeinformationsmodells;
- Fig. 2:: eine schematische Darstellung eines zweiten Ausführungsbeispiels des Verfahrens zur Generierung eines Gebäudeinformationsmodells;
- Fig. 3:: eine schematische Darstellung eines dritten Ausführungsbeispiels des Verfahrens zur Generierung eines Gebäudeinformationsmodells;
- Fig. 4:: eine schematische Darstellung eines Aspekts des Verfahrens zur Generierung eines Gebäudeinformationsmodells; und
- Fig. 5:: eine schematische Darstellung eines Systems zur Generierung eines Gebäudeinformationsmodells.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

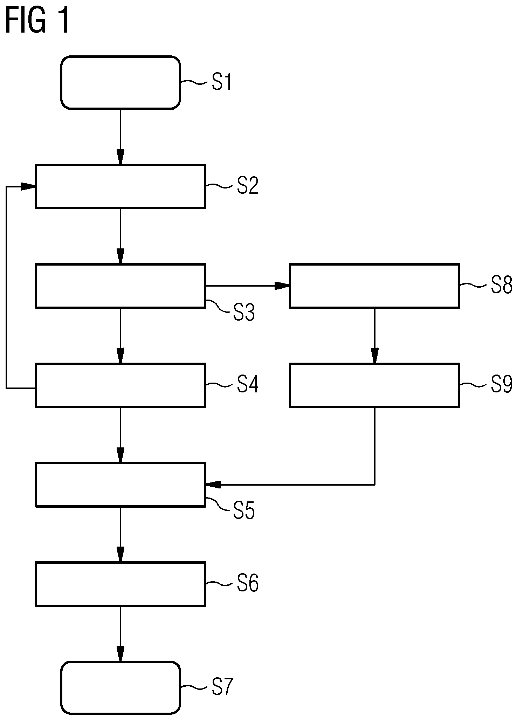

Figur 1 zeigt ein Flussdiagramm eines ersten Ausführungsbeispiels eines erfindungsgemäßen Verfahrens zur Generierung eines Gebäudeinformationsmodells, welches beispielsweise zur Bearbeitung eines Gebäudes genutzt werden kann. Das Flussdiagramm zeigt die Verfahrensschritte des Verfahrens.

Das Verfahren kann insbesondere zumindest teilweise computerimplementiert sein. Es umfasst folgende Verfahrensschritte:
Im ersten Schritt S1 des Verfahrens wird ein zweidimensionaler, digitalisierter Gebäudeplan des Gebäudes eingelesen. Der Gebäudeplan kann beispielsweise ein Grundriss oder ein Elektroinstallationsplan sein. Der Gebäudeplan umfasst Gebäudeobjekte und Gebäudeobjektdaten, die den Gebäudeobjekten zugeordnet sind. Beispielsweise umfasst ein Grundriss Positionen oder Maße, zu Wänden, Türen, Fenstern, etc. Ein Elektroinstallationsplan umfasst beispielsweise eine Position, Typ/Art, einer Steckdose, eines Schalters etc.

Im nächsten Schritt S2 des Verfahrens wird mindestens ein Teil, wie z.B. ein Raum, des Gebäudes mittels einer Abtasteinheit, wie z.B. einem Laser-Scanner, abgetastet und entsprechende dreidimensionale Gebäudedaten ausgegeben. Die dreidimensionalen Gebäudedaten können beispielsweise als Punktwolke vorliegen. Vorzugsweise wird für einen solchen Raumscan ein Startpunkt für den Laser-Scanner anhand des Gebäudeplans festgelegt. Der Raumscan kann vorzugsweise ausgehend von diesem Startpunkt entlang einer im Gebäudeplan vorgegebenen Trajektorie oder Route erfolgen, d.h. vorzugsweise bewegt sich der Scanner entlang der vorgegebenen Trajektorie und scannt dabei abschnittsweise das Gebäude.

Im nächsten Schritt S3 werden die dreidimensionalen Gebäudedaten mit dem Gebäudeplan verglichen, wobei mindestens ein Teilbereich des Gebäudeplans an einer Position der Abtasteinheit ausgewertet wird, und resultierende Vergleichsdaten werden ausgegeben. Vergleichsdaten können beispielsweise als Ergebnis des Vergleichs verstanden werden. Die Vergleichsdaten können beispielsweise eine Übereinstimmung oder eine Abweichung der dreidimensionalen Gebäudedaten mit dem Gebäudeplan umfassen. Insbesondere kann dieser Verfahrensschritt mittels eines dafür trainierten maschinellen Lernmodells durchgeführt werden, wobei das maschinelle Lernmodell vorzugsweise darauf trainiert ist, in Abhängigkeit von dreidimensionalen Gebäudedaten und dem zweidimensionalen Gebäudeplan, Vergleichsdaten auszugeben. Vergleichsdaten können in diesem Fall beispielsweise eine Wahrscheinlichkeitsangabe für eine Übereinstimmung der 3D-Daten mit dem 2D-Plan umfassen.

Im nächsten Verfahrensschritt S4 wird anhand der Vergleichsdaten mindestens ein Gebäudeobjekt detektiert, wie z.B. eine Wand. Die im Gebäudeplan hinterlegten Gebäudeobjektdaten dieses detektierten Gebäudeobjekts, wie z.B. eine Wandstärke oder ein Baumaterial, werden anschließend ausgegeben.

Vorzugsweise können die Verfahrensschritte S2 bis S4 iterativ wiederholt werden, um diese im Wesentlichen zeitlich parallel zum Abtasten des Gebäudes mittels der Abtasteinheit durchzuführen.

Alternativ oder zusätzlich zu Schritt S4 kann im Schritt S8 anhand der Vergleichsdaten eine Abweichung der dreidimensionalen Gebäudedaten vom Gebäudeplan detektiert werden. In diesem Fall können im Schritt S9 Gebäudeobjektdaten in Abhängigkeit der dreidimensionalen Gebäudedaten generiert werden. Beispielsweise kann anhand der dreidimensionalen Gebäudedaten eine Wand generiert und entsprechende dreidimensionale Daten, die eine Wand darstellen, bereitgestellt werden.

Im nächsten Schritt S5 wird das Gebäudeinformationsmodell aus den erfassten dreidimensionalen Gebäudedaten generiert. Dabei wird zunächst ein dreidimensionales, computergestütztes Modell des Gebäudes bzw. des gescannten Gebäudebereichs, erstellt.

Anschließend wird im Schritt S6 das detektierte und/oder das generierte Gebäudeobjekt in das Gebäudeinformationsmodell integriert. In anderen Worten, das Gebäudeinformationsmodell wird insbesondere um die Gebäudeobjektedaten ergänzt.

Im nächsten Schritt S7 wird das generierte Gebäudeinformationsmodell zum Bearbeiten des Gebäudes, wie z.B. für eine Wartung, eine Instandhaltung, eine bauliche Veränderung, etc. ausgegeben. Anschließend kann das Gebäude mittels des Gebäudeinformationsmodells beispielsweise gewartet, saniert, verändert, etc. werden.

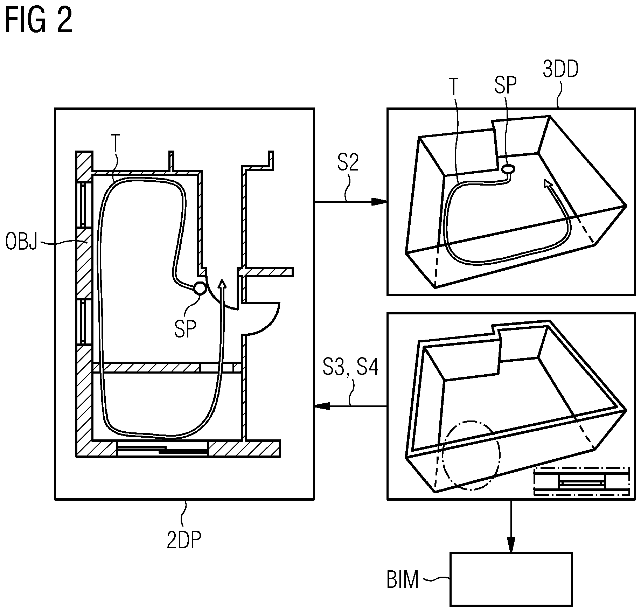

Figur 2 zeigt in schematischer Darstellung ein weiteres Ausführungsbeispiel des erfindungsgemäßen Verfahrens zur Generierung eines Gebäudeinformationsmodells, wie z.B. eines 3D-BIM-Modells, für zumindest einen Teil eines Gebäudes, wie z.B. eines Raums.

Es ist ein digitalisierter, zweidimensionaler Grundriss 2DP eines Raums eines Gebäudes gezeigt. Dieser kann als Ausgangspunkt für das Verfahren genutzt werden. Beispielsweise kann anhand des Grundrisses 2DP ein Startpunkt SP und eine Trajektorie T für einen Laser-Scanner zum Scannen des Raums festgelegt werden. Mittels des Laser-Scanners können, ausgehend vom Startpunkt SP entlang der Trajektorie T, dreidimensionale Gebäudedaten des Raums erfasst werden S2. Aus diesen dreidimensionalen Gebäudedaten kann ein dreidimensionales Gebäudeinformationsmodell BIM des Raums erstellt werden. Insbesondere kann die aus dem Scan erzeugte Punktwolke während des Scans mit dem Grundriss verglichen werden.

Durch iteratives Abgleichen S3 der dreidimensionalen Daten mit dem Gebäudeplan 2DP können Gebäudeobjekte OBJ ermittelt und entsprechende Gebäudeobjektdaten ausgegeben werden. Eine solche Synchronisierung kann beispielsweise durch das Fahren des Scanners entlang der vordefinierten Trajektorie T ermöglicht werden. Dieses Tracking-Verfahren hat insbesondere den Vorteil, dass die begrenzte Genauigkeit eines GPS-Signals im Gebäudeinneren im Gegensatz zur GPS-basierter Lokalisierung keine Rolle mehr spielt.

Beispielsweise kann derart eine Wand OBJ detektiert und eine Wandstärke anhand der Informationen im Gebäudeplan 2DP ermittelt werden. Die Gebäudeobjektdaten, wie z.B. die Wandstärke und/oder ein Wandmaterial, kann in das Gebäudeinformationsmodell BIM integriert werden. Außerdem können Abweichungen der dreidimensionalen Gebäudedaten vom Grundriss ermittelt und entsprechende Informationen in das Gebäudeinformationsmodell BIM aufgenommen werden.

Wird während des Scans gleichzeitig der Grundrissplan eines Gebäudes mitbetrachtet, können somit bereits Standardobjekte OBJ wie Türen, Fenster und/oder Sanitäranlagen mit ihren genormten Bezeichnungen und Abmessungen in das Gebäudemodell BIM übertragen werden. Somit ist es beispielsweise nicht nötig, dass eine integrierte Objekterkennung im Scangerät diese Standardelemente detektiert. Die freibleibenden Rechenressourcen können beispielsweise für die Erkennung verbleibender Gebäudeobjekte verwendet werden. Dadurch kann die benötigte Zeit für den Raum-Scan reduziert werden.

Weitere zusätzliche Information bietet der Grundrissplan bezüglich der Wände. So können die Wände während des Scans erkannt werden. Durch die parallele Betrachtung des Grundrisses können zusätzlich die entsprechenden Wandstärken und/oder Wandmaterialien, sowie die angrenzenden Räume im Modell definiert werden, ohne Zugriff auf die Geodaten des Scanners zu benötigen.

Zusätzlich zum Scan des Raums kann ebenfalls ein entsprechender Stromlaufplan oder ein Elektroinstallationsplan betrachtet werden. Insbesondere kann das Verfahren zusätzlich und/oder alternativ mit einem Elektroinstallationsplan anstatt einem Grundriss durchgeführt werden. Damit kann auch die technische Ausstattung eines Bestandgebäudes charakterisiert werden. Die einzelnen Ausstattungselemente können mithilfe eines Produktkatalogs und den hinterlegten Gebäudedaten, wie z.B. Datum der Installation der entsprechenden Gebäudetechnik, Hersteller der verbauten Geräte etc., genauer nach Gerätemodell/Gerätetyp eingegrenzt werden. Damit können beispielsweise auch Vorschläge zur Modernisierungsmaßnahmen gemacht werden.

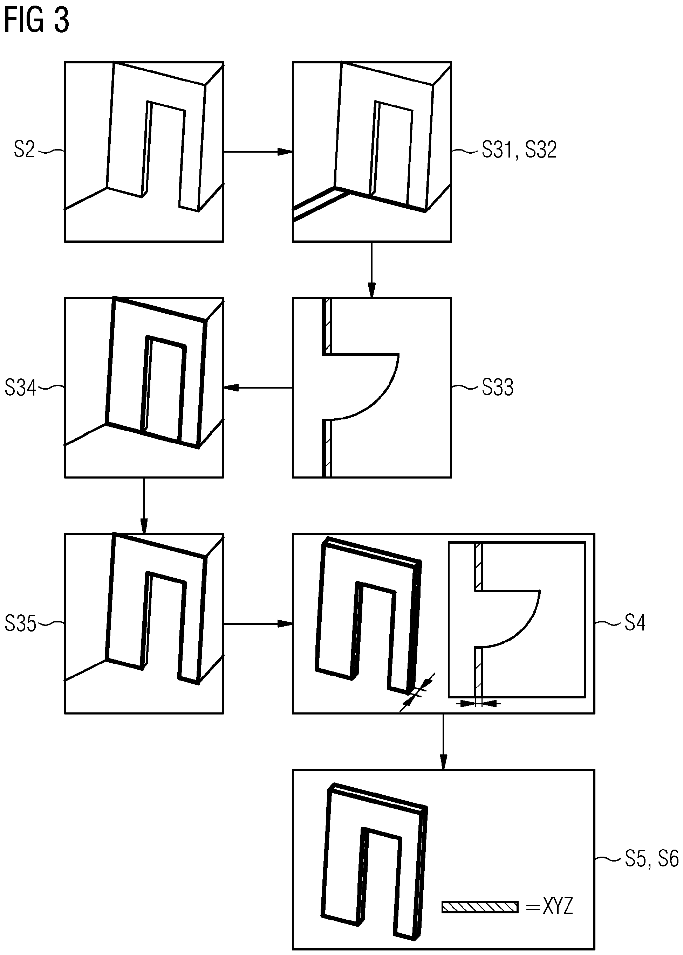

Figur 3 zeigt in schematischer Darstellung ein weiteres Ausführungsbeispiel des erfindungsgemäßen Verfahrens zur Generierung eines Gebäudeinformationsmodells, wie z.B. eines BIM-Modells, für ein Gebäude.

Vorzugsweise liegt für das Verfahren ein zweidimensionaler Gebäudeplan in digitalisierter/vektorisierter Form, wie z.B. als 2D CAD Plan, vor. Liegt der Gebäudeplan nur in Papierform oder als Scan vor, so wird zunächst eine Vektorisierung aller Linien und weiterer Primitiven durchgeführt, wofür bekannte Verfahren existieren.

In dem vektorisierten Gebäudeplan wird optional ein Startpunkt für das Verfahren zur Generierung des BIM-Modells gewählt, der auch in der realen Umgebung, z.B. in einem Raum des Gebäudes, aufgefunden werden kann. Der Startpunkt besitzt vorzugsweise mindestens eine, lokal eindeutige, geometrisch beschreibbare Eigenschaft, wie z.B. ein Eckpunkt der Wand. Diese Eigenschaft kann auch für einen Scanner in der realen Umgebung wiedergefunden werden. Das Festlegen eines Startpunkts ist insbesondere vorteilhaft, wenn das Gebäude eine Vielzahl gleichartiger Räume hat, wie z.B. ein Hotel oder ein Krankenhaus. Das Festlegen eines Startpunkts kann entfallen, wenn die aufgenommene Abfolge von Eigenschaften eindeutig einem Raum im Plan zugeordnet werden kann. In diesem Fall kann der Startpunkt des Verfahrens beispielsweise automatisch gefunden werden.

Ausgehend vom Startpunkt wird mittels des Scanners der Raum entlang- einer vorgegebenen Trajektorie gescannt, vorzugsweise so lange bis ein weiteres eindeutiges Merkmal bzw. Gebäudeobjekt im Scan und im Gebäudeplan erkannt wird, wie z.B. eine Raumecke, ein Einbaumöbel etc. Eine Aufnahme vom Boden und der Decke kann analog erfolgen. Die so aus dem Scan generierte Punktwolke kann nun anhand der bekannten Strukturen aus dem 2D-Plan korrigiert werden und es wird daraus ein Teil für ein 3D-BIM-Modell generiert (siehe unten). Danach kann das detektierte Gebäudeobjekt als neuer Startpunkt gesetzt und das Verfahren wiederholt werden, vorzugsweise, bis der ursprüngliche Startpunkt erreicht wird. Das Verfahren kann sowohl online, d.h. während des Scans, oder offline im Zuge einer nachträglichen Datenauswertung erfolgen.

Es kann bei dem Verfahren auch keine Übereinstimmung zwischen dem aktuell gescannten Gebäudebereich bzw. Gebäudeobjekt und einem nächsten zu erwartenden Gebäudeobjekt im Gebäudeplan erkannt werden. Beispielsweise kann dies der Fall sein, wenn am Gebäude Änderungen vorgenommen wurden, die nicht im 2D-Gebäudeplan enthalten sind. In einem solchen Fall können passende 2D-Gebäudeobjekte generiert werden. Vorzugsweise werden Gebäudeobjekte generiert, die möglichst gut zum aktuellen Scan passen, d.h. im Wesentlichen mit den dreidimensionalen Gebäudedaten übereinstimmen. Vorzugsweise können Gebäudeobjekte vorgeschlagen werden, die vordefinierten, bewährten Mustern entsprechen, wie zum Beispiel, dass eine Wand eine gerade Fläche ist, die in der Regel im 90° Winkel auf eine andere Wand trifft. Beispielsweise können solche 2D-Gebäudeobjekte in einer Bibliothek gespeichert vorliegen. Beispielsweise kann dann im Gebäudeinformationsmodell eine Wand im Gebäudeplan hinzugefügt werden, um eine Übereinstimmung mit den dreidimensionalen Gebäudedaten zu erzielen. Falls kein Gebäudeobjekt hinzugefügt werden kann, welches zu einer Übereinstimmung führt, kann alternativ auch die unbearbeitete Punktwolke in das generierte Gebäudeinformationsmodell übernommen werden bzw. entsprechend in den zweidimensionalen Gebäudeplan projiziert werden.

Das Verfahren zur Generierung eines 3D-BIM Modells ausgehend von einem vorliegenden, zweidimensionalen Gebäudeplan kann wie folgt ablaufen:
Zunächst wird mittels eines Scanners ein Abschnitt des Raums des Gebäudes gescannt. Als Ergebnis des Scans werden dreidimensionale Gebäudedaten ausgegeben. Nachdem der entsprechende Abschnitt des Raums gescannt wurde, S2, werden aus diesem Abschnitt Linien generiert, die den entsprechenden Abschnitt in 2D CAD repräsentieren, S31, S32.

Dazu werden die dreidimensionalen Gebäudedaten mit dem Gebäudeplan verglichen, wobei mindestens ein Teilbereich des Gebäudeplans an einer Position der Abtasteinheit ausgewertet wird. Dies umfasst das Bestimmen S31 einer horizontalen Struktur anhand der dreidimensionalen Gebäudedaten. Für diese horizontale Struktur wird eine erste Linie generiert S32. Das Verfahren basiert darauf, dass Strukturen in Gebäuden, die in einen 2D Plan eingezeichnet werden, in der Regel senkrecht zur Oberfläche stehen.

Die horizontale Struktur kann beispielsweise anhand der dreidimensionalen Gebäudedaten detektiert werden, indem in vertikaler Richtung übereinanderliegende Datenpunkte gezählt werden. Es werden dann diejenigen obersten Datenpunkte horizontal miteinander verbunden, die im Wesentlichen, d.h. innerhalb einer vorgegebenen Ungenauigkeit, auf derselben Höhe liegen. In anderen Worten, es werden horizontale Linien aus benachbarten Datenpunkten gebildet, sofern die benachbarten Datenpunkte in vertikaler Richtung eine im Wesentlichen/innerhalb eines vorgegebenen Toleranzbereichs übereinstimmende Anzahl aufweisen. Vorzugsweise können Datenpunkte derart zu einer möglichst langen Linie oder anderen grafischen Primitiven zusammengefasst werden. Beispielsweise können die jeweiligen obersten Datenpunkte, die eine solche horizontale Struktur bilden, bestimmt werden, in dem die Scanpunkte gezählt werden.

Die so gewonnenen Linien bzw. Primitiva werden nun mit den Linien im zweidimensionalen Gebäudeplan verglichen S33, wobei vorzugsweise ein minimaler Abstand zwischen der gewonnenen Linie und der Struktur des Gebäudeplans bestimmt wird. Vorzugsweise wird eine optimierte Zuordnung bestimmt. Dabei kann insbesondere die Position des Scanners im Raum bzw. im Gebäudeplan berücksichtigt werden.

Anschließend kann die Position der dreidimensionalen Gebäudedaten bzw. der Punktwolke des Scans, die der ersten Linie zugeordnet sind/ist, korrigiert werden S34. Beispielsweise können die räumlichen Koordinaten der dreidimensionalen Gebäudedaten, die der ersten Linie zugeordnet sind, in Abhängigkeit der Position der zweiten Linie korrigiert werden. Dabei können beispielsweise die zu der Linie gehörigen Punkte so in vertikaler oder horizontaler Richtung verschoben werden, dass sie mit der zugeordneten Linie des Gebäudeplans übereinstimmen. Damit können beispielsweise Positionsungenauigkeiten im Scan, wie z.B. in Ecken, ausgeglichen werden. Zusätzlich kann eine durch den Scanner aufgenommene Bild-Textur, wie z.B. eine Oberflächenbeschaffenheit einer Wand (z.B. Ziegelwand), auf die Punkte übertragen werden. Diese Informationen aus den dreidimensionalen Daten können anschließend ebenfalls in das 3D-BIM-Modell (siehe unten) übernommen werden.

Eine im 2D Gebäudeplan nicht enthaltene Ausdehnung eines detektierten Gebäudeobjekts in z-Richtung/vertikaler Richtung wird aus der Punktwolke entnommen S35. Dies kann beispielsweise unter der Annahme bestimmt werden, dass Linien parallel zum Boden verlaufen, so dass entsprechende Datenpunkte in vertikaler Richtung gezählt und in eine Höhenangabe umgerechnet werden können.

Anschließend kann geprüft werden S4, ob die den dreidimensionalen Gebäudedaten zugeordnete Linie im Gebäudeplan zu einer übergeordneten Struktur bzw. zu einem Gebäudeobjekt gehört. Im gezeigten Beispiel gehört die 2D Linie zu einem Polygon mit Schraffur im 2D Plan, das laut Schraffur eine Wand beschreibt.

Aus den dreidimensionalen Gebäudedaten aus dem Scan kann ein 3D-BIM-Modell generiert werden. Das 3D-BIM-Modell kann insbesondere als Datenstruktur ausgegeben werden. Das 3D-BIM-Modell kann zur Bearbeitung des Gebäudes, wie z.B. zur Sanierung oder Renovierung, angewandt werden.

Die aus dem Scan gewonnene Oberfläche des BIM-Objekts, z.B. Ziegelstruktur des Wandelements, kann in dem 3D-BIM-Modell gespeichert werden. Beispielsweise kann ein Baumaterialtyp "Ziegel" für das BIM-Objekt gespeichert werden. Die entsprechende Wanddicke und/oder ein Baumaterial der Wand XYZ kann anhand des Gebäudeplans ermittelt und in das BIM-Modell eingetragen werden S6. Dabei genügt es vorzugsweise lediglich die Eckpunkte der Wand zu übernehmen und diese mit Linien zu verbinden. Aus den restlichen Punkten kann optional eine Textur für die bekannte Vorderseite des Objekts generiert werden und zusammen mit dem BIM Objekt abgelegt werden. Zudem können bestimmte Eigenschaften und Objekte ergänzt werden, die in Beschreibungen im Plan zu finden sind. So können beispielsweise Fenster, Rohre oder Stahlträger ergänzt werden, die laut 2D-Gebäudeplan in der entsprechenden Wand enthalten sind. Für die Ausdehnung dieser Objekte in z-Richtung werden vorzugsweise bestimmte Annahmen getroffen (z.B. standardisierte Längen). Außerdem können diese Objekte auch als Startpunkt für eine weitergehende Modellierung dienen.

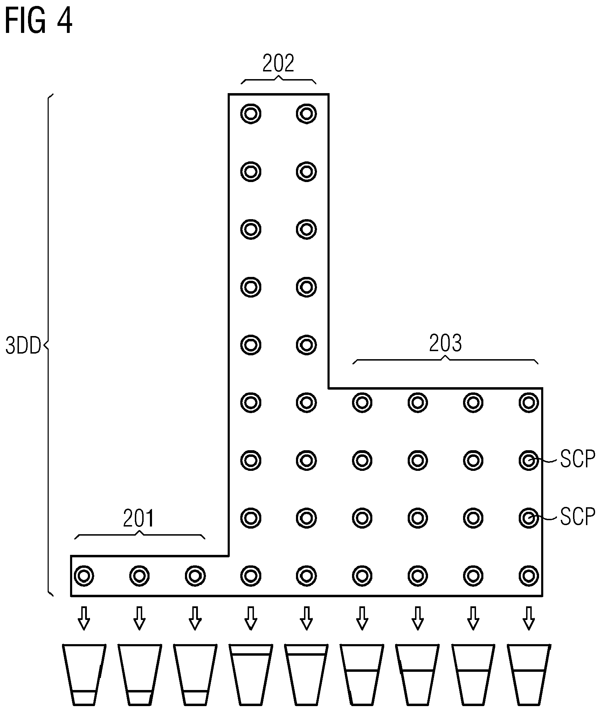

Figur 4 zeigt schematisch ein Ausführungsbeispiel eines Aspekts des Verfahrens zur Generierung eines Gebäudeinformationsmodells.

Es ist eine Variante des Verfahrensschritts des Vergleichens S3 der dreidimensionalen Gebäudedaten 3DD mit dem Gebäudeplan, der beispielhaft in Figur 1 bis 3 gezeigt ist, schematisch skizziert.

Anhand der dreidimensionalen Gebäudedaten 3DD, die beispielsweise als einzelne Datenpunkte bzw. Scanpunkte SCP eine Punktwolke bilden, wird eine horizontale Struktur bestimmt. Dabei wird die horizontale Struktur anhand der dreidimensionalen Gebäudedaten 3DD bestimmt, indem in vertikaler Richtung übereinanderliegende Datenpunkte/Scanpunkte SCP gezählt werden.

Die Zählung der übereinanderliegenden Daten- bzw. Scanpunkte SCP kann analog zu einer gedachten Niederschlagsberechnung erfolgen. Die Scanpunkte fallen dabei im Algorithmus wie (gedachter) Niederschlag zu Boden und werden dort von gedachten Messbechern aufgesammelt. Wenn benachbarte Messbecher im Wesentlichen innerhalb einer vorgegebenen Messungenauigkeit dieselbe Anzahl Scanpunkte enthalten, wird daraus abgeleitet, dass sie zum selben Element gehören, wie z.B. eine raumhohe Wand oder Möbelstück. In anderen Worten, die in z-Richtung übereinanderliegenden Scanpunkte SCP werden vorzugsweise addiert und jeweils die Anzahl der Scanpunkte in horizontaler Richtung miteinander verglichen.

Auf diese Weise kann beispielsweise ein Bereich des Bodens 201, der Wand 202 und/oder eines Möbelstücks 203 bestimmt werden. Vorzugsweise werden bei der Bestimmung eines solchen Gebäudeobjekts horizontal benachbarte Scanpunkte betrachtet.

Wenn die benachbarten Daten-/Scanpunkte SCP in vertikaler Richtung eine im Wesentlichen und/oder innerhalb eines vorgegebenen Toleranzbereichs übereinstimmende Anzahl aufweisen, können sie horizontal miteinander mit einer Linie verbunden werden. Auf diese Weise wird eine Line oder andere grafische Primitiven erzeugt. Diese erzeugte Linie kann anschließend mit einer Linie eines zweidimensionalen Gebäudeplans verglichen werden, um Gebäudeobjekte im Gebäudeplan zu bestimmen, die den dreidimensionalen Gebäudedaten entsprechen.

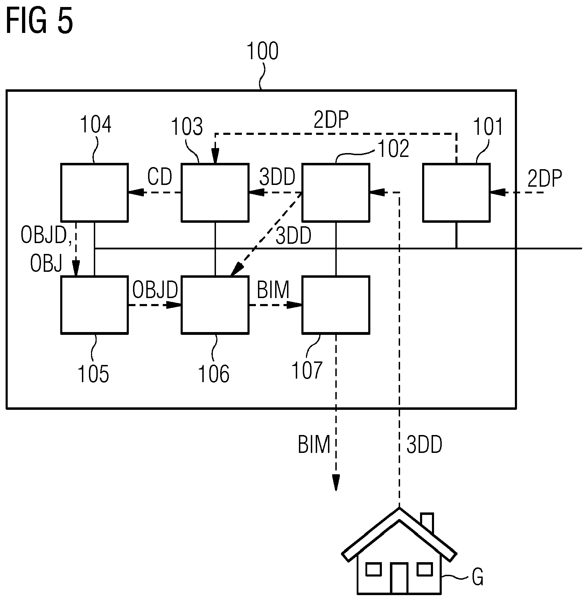

Figur 5 zeigt ein Ausführungsbeispiel eines erfindungsgemäßen Systems 100 zur Generierung eines Gebäudeinformationsmodells für ein Gebäude G in schematischer Blockdarstellung.

Das System 100 umfasst eine Schnittstelle 101, eine Abtasteinheit 102, eine Vergleichseinheit 103, eine Detektionseinheit 104, einen Modellgenerator 105, eine Integrationseinheit 106 und eine Ausgabeeinheit 107. Die einzelnen Einheiten bzw. Komponenten des Systems 100 sind insbesondere untereinander über Kommunikationsverbindungen verbunden, d.h. sie können miteinander Daten austauschen.

Das System 100 kann insbesondere mindestens einen Prozessor umfassen und insbesondere Hardware- und Softwarekomponenten umfassen. Insbesondere können die jeweiligen Einheiten jeweils Schnittstellen, und/oder eine Speichereinheit umfassen, um Daten, wie z.B. Gebäudedaten, zu prozessieren.

Die Schnittstelle 101 ist derart eingerichtet, einen zweidimensionalen Gebäudeplan 2DP des Gebäudes G, wie z.B. einen Grundriss oder einen Elektroinstallationsplan einzulesen. Der zweidimensionale Gebäudeplan umfasst Gebäudeobjekte und Gebäudeobjektdaten, die den Gebäudeobjekten zugeordnet sind. Der Gebäudeplan liegt vorzugsweise als Datei oder Datenstruktur vor. Die Gebäudeobjekte im Gebäudeplan sind beispielsweise schematische, zweidimensionale Abbildungen oder digitale Repräsentationen von realen/physischen Gebäudeobjekten im realen Gebäude.

Die Abtasteinheit 102 ist derart eingerichtet, dreidimensionale Gebäudedaten von mindestens einem Teil des Gebäudes zu erfassen, Die Abtasteinheit 102 kann beispielsweise ein Scanner/Laser-Scanner sein. Die Abtasteinheit 102 scannt mindestens einen Teilbereich des Gebäudes und liefert Datenpunkte in einem kartesischen Koordinatensystem, die als Punktwolke eine dreidimensionale Ansicht des gescannten Teilbereichs reproduzieren. Die Abtasteinheit 102 kann insbesondere mobil ausgestaltet sein, wobei sie beispielsweise über eine drahtlose Kommunikationsverbindung zum Übermitteln der erfassten dreidimensionalen Gebäudedaten mit den übrigen Einheiten des Systems 100 verbunden ist. So kann sich die Abtasteinheit 102 beispielsweise entlang einer anhand des Gebäudeplans bestimmten Route/Trajektorie bewegen und derart das Gebäude G scannen.

Die Vergleichseinheit 103 ist derart eingerichtet, die dreidimensionalen Gebäudedaten 3DD mit dem Gebäudeplan 2DP zu vergleichen, wobei mindestens ein Teilbereich des Gebäudeplans an der Position der Abtasteinheit ausgewertet wird. Dabei werden insbesondere die dreidimensionalen Gebäudedaten mit den zweidimensionalen Daten des Gebäudeplans verglichen, wie beispielhaft anhand Figur 3 erläutert. Weiter ist die Vergleichseinheit 103 dazu eingerichtet, entsprechende Vergleichsdaten CD als Ergebnis dieses Vergleichs auszugeben. Die Vergleichsdaten CD können eine Übereinstimmung oder eine Abweichung der dreidimensionalen Gebäudedaten mit dem Gebäudeplan umfassen. Dieser Datenvergleich erfolgt vorzugsweise für die Daten des Gebäudeplans an der Position und/oder in der Umgebung der Abtasteinheit 102. In anderen Worten, vorzugsweise werden lediglich Daten des Gebäudeplans in einem vorgegebenen Bereich an der aktuellen Position der Abtasteinheit 102 für den Vergleich betrachtet.

Die Detektionseinheit 104 ist derart eingerichtet, anhand der Vergleichsdaten CD mindestens ein Gebäudeobjekt OBJ im Gebäudeplan zu detektieren und Gebäudeobjektdaten OBJD, die dem detektierten Gebäudeobjekt zugeordnet sind, und/oder das Gebäudeobjekt OBJ auszugeben. Im Fall, dass die Vergleichsdaten CD eine Abweichung zwischen den dreidimensionalen Gebäudedaten 3DD und dem Gebäudeplan 2DP umfassen, kann das System 100 weiter eine Objektgenerierungseinheit umfassen (nicht gezeigt), die dazu eingerichtet ist, ein Gebäudeobjekt und entsprechende Gebäudeobjektdaten in Abhängigkeit der dreidimensionalen Gebäudedaten zu generieren und der Integrationseinheit bereit zu stellen.

Der Modellgenerator 105 ist derart eingerichtet, aus den dreidimensionalen Gebäudedaten 3DD das Gebäudeinformationsmodell zu generieren. Der Modellgenerator 105 erstellt somit ein 3D-Modell aus den erfassten dreidimensionalen Gebäudedaten, die die Abtasteinheit 103 erfasst hat.

Die Integrationseinheit 106 ist derart eingerichtet, das detektierte Gebäudeobjekt OBJ und die zugeordneten Gebäudeobjektdaten OBJD in das Gebäudeinformationsmodell BIM zu integrieren. Beispielsweise kann unter "Integrieren" ein einlesen, speichern und/oder mit dem dreidimensionalen Modell verlinken verstanden werden.

Die Ausgabeeinheit 107 ist derart eingerichtet, das generierte Gebäudeinformationsmodell zum Bearbeiten des Gebäudes auszugeben. Das Gebäude G kann beispielsweise mit Hilfe des Gebäudeinformationsmodells BIM bearbeitet, wie z.B. renoviert, werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zur Generierung eines Gebäudeinformationsmodells zum Bearbeiten eines Gebäudes, umfassend die Verfahrensschritte:
a) Einlesen (S1) eines zweidimensionalen, digitalisierten Gebäudeplans (2DP) des Gebäudes, wobei der Gebäudeplan Gebäudeobjekte und Gebäudeobjektdaten, die den Gebäudeobjekten zugeordnet sind, umfasst,
b) Erfassen (S2) dreidimensionaler Gebäudedaten (3DD) von mindestens einem Teil des Gebäudes mittels einer Abtasteinheit (102),
c) Vergleichen (S3) der dreidimensionalen Gebäudedaten (3DD) mit dem Gebäudeplan (2DP), wobei mindestens ein Teilbereich des Gebäudeplans an einer Position der Abtasteinheit ausgewertet wird, und Ausgeben von Vergleichsdaten (CD),
d) Detektieren (S4) von mindestens einem Gebäudeobjekt (OBJ) im Gebäudeplan (2DP) anhand der Vergleichsdaten (CD) und Ausgeben von Gebäudeobjektdaten (OBJD), die dem detektierten Gebäudeobjekt zugeordnet sind,
e) Generieren (S5) des Gebäudeinformationsmodells (BIM) aus den dreidimensionalen Gebäudedaten,
f) Integrieren (S6) des detektierten Gebäudeobjekts (OBJ) und die zugeordneten Gebäudeobjektdaten (OBJD) in das Gebäudeinformationsmodell,
und
g) Ausgeben (S7) des generierte Gebäudeinformationsmodells zum Bearbeiten des Gebäudes.

2. Verfahren nach Anspruch 1, wobei die dreidimensionalen Gebäudedaten durch Abtasten des Gebäudes mittels der Abtasteinheit entlang einer im Gebäudeplan definierten Trajektorie (T) erfasst werden.

3. Verfahren nach einem der vorhergehenden Ansprüche, wobei anhand des Gebäudeplans ein Startpunkt bestimmt wird und die dreidimensionalen Gebäudedaten ausgehend von diesem Startpunkt (SP) erfasst werden.

4. Verfahren nach einem der vorhergehenden Ansprüche, wobei die Verfahrensschritte b) bis d) nach vorgegebenen Zeitschritten wiederholt werden.

5. Verfahren nach einem der vorhergehenden Ansprüche, wobei die Verfahrensschritte b) bis d) nach einer Detektion eines Gebäudeobjektes wiederholt werden.

6. Verfahren nach einem der vorhergehenden Ansprüche, wobei anhand der Vergleichsdaten eine Abweichung der dreidimensionalen Gebäudedaten vom Gebäudeplan detektiert wird (S8).

7. Verfahren nach Anspruch 6, wobei, falls eine Abweichung erkannt wird, ein Gebäudeobjekt und entsprechende Gebäudeobjektdaten in Abhängigkeit der dreidimensionalen Gebäudedaten generiert (S9) und in das Gebäudeinformationsmodell integriert werden.

8. Verfahren nach einem der vorhergehenden Ansprüche, wobei der Verfahrensschritt (S3) des Vergleichens der dreidimensionalen Gebäudedaten mit dem Gebäudeplan folgende Teilschritte umfasst:
- Bestimmen (S31) einer horizontalen Struktur anhand der dreidimensionalen Gebäudedaten,
- Generieren (S32) einer ersten Linie anhand der horizontalen Struktur,
- Vergleichen (S33) der ersten Linie mit Linien des Gebäudeplans, wobei die erste Linie einer zweiten Linie des Gebäudeplans zugeordnet wird,
und
- Korrigieren (S34) der räumlichen Koordinaten der dreidimensionalen Gebäudedaten, die der ersten Linie zugeordnet sind, in Abhängigkeit der Position der zweiten Linie.

9. Verfahren nach Anspruch 8, wobei das mindestens eine Gebäudeobjekt anhand der zweiten Linie im Gebäudeplan detektiert wird.

10. Verfahren nach einem der Ansprüche 8 oder 9, wobei die horizontale Struktur anhand der dreidimensionalen Gebäudedaten detektiert wird, indem in vertikaler Richtung übereinanderliegende Datenpunkte gezählt werden und horizontal mit benachbarten Datenpunkten entlang des jeweilig obersten Datenpunkts verbunden werden, sofern die benachbarten Datenpunkte in vertikaler Richtung eine im Wesentlichen übereinstimmenden Anzahl aufweisen.

11. Verfahren nach einem der Ansprüche 1 bis 7, wobei der Verfahrensschritt des Vergleichens der dreidimensionalen Gebäudedaten mit dem Gebäudeplan mittels eines dafür trainierten maschinellen Lernmodells durchgeführt wird.

12. Verfahren nach einem der vorhergehenden Ansprüche, wobei der Gebäudeplan ein Grundriss oder ein Elektroinstallationsplan ist.

13. Verfahren nach einem der vorhergehenden Ansprüche, wobei das Gebäudeinformationsmodell ein BIM-Modell ist.

14. System (100) zur Generierung eines Gebäudeinformationsmodells zum Bearbeiten eines Gebäudes, umfassend:
- eine Schnittstelle (101), die derart eingerichtet ist, einen zweidimensionalen Gebäudeplan des Gebäudes einzulesen, wobei der zweidimensionale Gebäudeplan Gebäudeobjekte und Gebäudeobjektdaten, die den Gebäudeobjekten zugeordnet sind, umfasst,
- eine Abtasteinheit (102), die derart eingerichtet ist, dreidimensionale Gebäudedaten von mindestens einem Teil des Gebäudes zu erfassen,
- eine Vergleichseinheit (103), die derart eingerichtet ist, die dreidimensionalen Gebäudedaten mit dem Gebäudeplan zu vergleichen, wobei mindestens ein Teilbereich des Gebäudeplans an der Position der Abtasteinheit ausgewertet wird, und Vergleichsdaten auszugeben,
- eine Detektionseinheit (104), die derart eingerichtet ist, anhand der Vergleichsdaten mindestens ein Gebäudeobjekt im Gebäudeplan zu detektieren und Gebäudeobjektdaten, die dem detektierten Gebäudeobjekt zugeordnet sind, auszugeben,
- einen Modellgenerator (105), der derart eingerichtet ist, aus den dreidimensionalen Gebäudedaten das Gebäudeinformationsmodell zu generieren,
- eine Integrationseinheit (106), die derart eingerichtet ist, das detektierte Gebäudeobjekt und die zugeordneten Gebäudeobjektdaten in das Gebäudeinformationsmodell zu integrieren,
und
- eine Ausgabeeinheit (107), die derart eingerichtet ist, das generierte Gebäudeinformationsmodell zum Bearbeiten des Gebäudes auszugeben.

15. Computerprogrammprodukt, das direkt in einen programmierbaren Computer ladbar ist, umfassend Programmcodeteile, die dazu geeignet sind, die Schritte des Verfahrens nach einem der Ansprüche 1 bis 13 durchzuführen.
